# EUROPEAN PATENT SPECIFICATION

(11) **EP 3 164 887 B1**
(45) Date of publication and mention of the grant of the patent: **02.12.2020**
(21) Application number: 15815539.0
(22) Date of filing: 01.07.2015
(51) Int. Cl.: H01L 23/538, H01L 21/56, H01L 23/31

(54) **STRUCTURE AND METHOD OF BATCH-PACKAGING LOW PIN COUNT EMBEDDED SEMICONDUCTOR CHIPS**
STRUKTUR UND VERFAHREN ZUR CHARGENVERARBEITUNG VON EINGEBETTETEN HALBLEITERCHIPS MIT GERINGER PIN-ZAHL
STRUCTURE ET PROCÉDÉ DE TRAITEMENT PAR LOTS DE PUCES SEMI-CONDUCTRICES EMBALLÉES À BAS NOMBRE DE CONTACTS

(30) Priority: 01.07.2014 US 201414320825
(43) Date of publication of application: 10.05.2017
(73) Proprietor: Texas Instruments Incorporated, Dallas, TX 75265-5474 (US)
(72) Inventor: MASUMOTO, Mutsumi, Beppu, Oita 8740012 (JP)
(74) Representative: Zeller, Andreas
(86) International application number: PCT/US2015/038880
(87) International publication number: WO 2016/004238

(56) References cited:
- EP-A1- 2 184 776
- WO-A1-2014/071312
- US-A1- 2007 111 379
- US-A1- 2008 023 821
- US-A1- 2012 025 242
- US-A1- 2012 241 925
- US-A1- 2013 244 377

## Description

This relates generally to semiconductor devices and processes, and more particularly to a structure and fabrication method of batch-packaging low pin count embedded semiconductor chips.

### BACKGROUND

It is common practice to manufacture the active and passive components of semiconductor devices into round wafers sliced from elongated cylinder-shaped single crystals of semiconductor elements or compounds. The diameter of these solid state wafers may reach up to 12 inches. Individual devices are then typically singulated from the round wafers by sawing streets in x- and y-directions through the wafer to create rectangularly shaped discrete pieces from the wafers. Commonly, these pieces are referred to as die or chips. Each chip includes at least one device coupled with respective metallic contact pads. Semiconductor devices include many large families of electronic components. Examples are active devices such as diodes and transistors like field-effect transistors, passive devices such as resistors and capacitors, and integrated circuits with sometimes far more than a million active and passive components.

After singulation, one or more chips are attached to a discrete supporting substrate, such as a metal leadframe or a rigid multi-level substrate laminated from multiple metallic and insulating layers. The conductive traces of the leadframes and substrates are then connected to the chip contact pads, typically using bonding wires or metal bumps such as solder balls. For protection against environmental and handling hazards, the assembled chips may be encapsulated in discrete robust packages, which frequently employ hardened polymeric compounds and are formed by techniques such as transfer molding. The assembly and packaging processes are usually performed, either on an individual basis or in small groupings (such as a strip of leadframe or a loading of a mold press).

To increase productivity by a quantum jump and reduce fabrication cost, technical efforts have recently been initiated to increase the volume handled by each batch process step. These efforts are generally summarized under the title panelization. As an example, adaptive patterning methods have been described for fabricating panel-based package structures. Other technical efforts are directed to keep emerging problems such as panel warpage under control. WO 2014/071312 relates to a semiconductor device and method of adaptive patterning for panelized packaging. US 2013/0244377 relates to a heat-resistant pressure-sensitive adhesive tape for production of a semiconductor device and a respective method

### SUMMARY

In a process flow for a whole set of chips to embed the chips in the packages, a method uses adhesive tapes instead of epoxy chip attach procedures, re-usable carriers, and a sputtering methodology for replacing electroless plating. Furthermore, the new process technology is free of the need to use lasers. As a result, the new process flow preserves clean chip contact pads and processes a set of four chips concurrently, thus greatly increasing productivity. Also, the packaged devices offer improved reliability. A key contributor to the enhanced reliability is reduced thermo-mechanical stress achieved by laminating gaps with insulating fillers having high modulus and a glass transition temperature for a coefficient of thermal expansion approaching the coefficient of silicon.

In a sputtering technology with plasma-cleaned and cooled panels, uniform sputtered metal layers are produced across a panel, and thus avoids the need for electroless plating. Because the sputtering procedure also serves to clean and roughen the substrate surface, the sputtered layers adhere equally well to dielectrics, silicon, and metals. They may be employed as connective traces, or may serve as seed layers for subsequent electro-plated metal layers.

One embodiment based on the modified processes can be applied to a set of contiguous chips with small numbers of terminals. Another embodiment lends itself to multiple sets of semiconductor chips. Many modified flows are applicable to any transistor or integrated circuit. Other modified flows are particularly suitable for higher numbers of terminals. Some of the packaged devices offer flexibility with regard to the connection to external parts. They can be finished to be suitable as devices with land grid arrays, or as ball grid arrays, or as and QFN (quad flat no-lead) terminals.

### BRIEF DESCRIPTION OF THE DRAWINGS

FIG. 1 shows a cross section of a re-usable carrier with a triple level adhesive tape as used by described examples.
FIG. 2A is a cross section of the carrier of FIG. 1 illustrating the process of attaching a set of chips onto the top adhesive layer of the carrier.
FIG. 2B is a top view of the assembly illustrating the process of attaching a set of four chips onto the top adhesive layer of the carrier.
FIG. 3 shows a cross section of the assembly illustrating the process of laminating a polymeric filler material over the assembly.
FIG. 4A is a cross section of the assembly illustrating the process of grinding the filler material to exposed the bumped chip terminals.
FIG. 4B is a top view of the assembly illustrating the exposed bumped chip terminals after grinding the filler material.
FIG. 5A is a cross section of the assembly summarizing the processes of depositing and patterning at least one metal layer to form extended contact pads and reroute connections between pads and chip terminals.
FIG. 5B displays a top view of the deposited and patterned at least one metal layer forming extended contact pads and rerouted connections between pads and chip terminals.
FIG. 6A shows a cross section of the assembly depicting the process of depositing and pattering a protective insulator layer.
FIG. 6B is a top view of the assembly illustrating the assembly surface covered by the protective layer with openings for the expended contact pads.
FIG. 7A illustrates the process of singulating discrete devices from the packaged set, after the carrier has been separated.
FIG. 7B shows a top view of singulated packaged devices singulated from the set.

### DETAILED DESCRIPTION OF EXAMPLE EMBODIMENTS

The object underlying the present invention is achieved by a method of manufacturing packaged semiconductor devices according to claim 1 and by a package semiconductor device according to claim 4. Key technical challenges are resolved by successful methods and process flows for large-scale panels from sets of few contiguous chips to sets of larger numbers of contiguous chips, as intended for semiconductor packaging. These challenges include achieving planarity of panels and avoiding warpage and mechanical instability, extending the spacing of contact pads for easy connection to external parts, achieving low resistance connections and reaching high reliability backside chip connects, avoiding expensive laser process steps, especially through metal layers and epoxy layers, and improved thermal characteristics. For metallic seed layers, uniformity of the layers across the selected panel size should be achieved, yet electroless plating technology should be avoided.

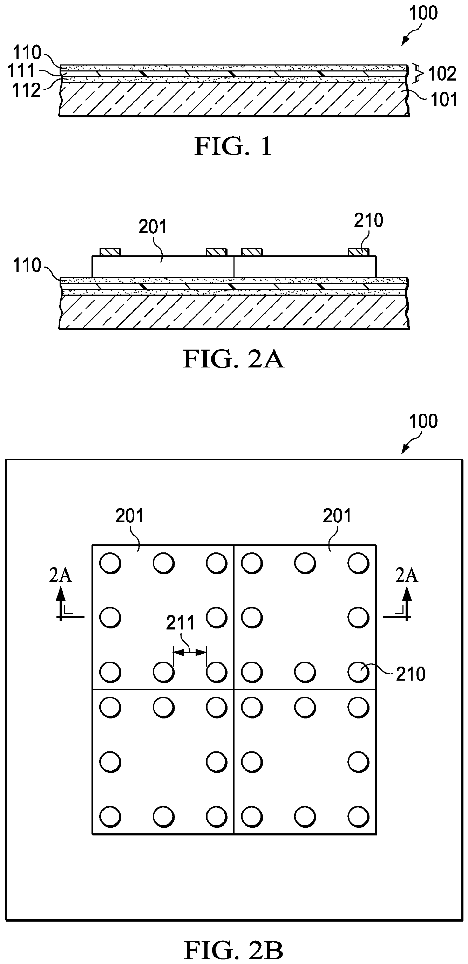

At least one embodiment includes a method of fabricating packaged semiconductor devices in panel format, certain processes of which are illustrated in FIGS. 1 to 7B. The method starts in FIG. 1 by selecting a flat panel sheet as a rigid carrier generally designated 100. Carrier 100 includes a stiff substrate 101 and a tape 102. Substrate 101 is an insulating plate suitable to maintain panel flatness. For example, substrate 101 may be made of glass or another stiff inorganic or organic material. Tape 102 includes preferably a 3-layer tacky foil, which includes a surface layer 110 of a first adhesive releasable at elevated temperatures, a core base film 111, and a bottom layer 112 with a second adhesive. Bottom layer 112 is attached to the substrate 101. The composition of carrier 100 ensures the carrier will not become permanent part of the final packaged device. Alternatively, carrier 100 may be endowed with a composition, which allows the incorporation of the panel in the final device package. The panel 100 has lateral dimensions suitable for a set of contiguous semiconductor chips. In the example embodiment of FIGS.2A and 2B, panel 100 has lateral dimensions greater than four contiguous semiconductor integrated circuit chips arranged as a unit (e.g., four chips fabricated in single-crystalline silicon and not yet singulated).

The capability to process a set of four semiconductor chips as a single batch, enhances the productivity of the involved process steps fourfold.

FIGS. 2A and 2B show the process step of attaching a set of four contiguous semiconductor chips to first adhesive layer 110 of the dielectric tape 102 of carrier 100. FIG. 2B illustrates the set of four square-shaped chips arranged as a large-size square to take advantage of redesigning the contact pads in a symmetrical geometry. More generally, the chip set forms a rectangle with sidewalls. Alternatively, other unsymmetrical rearrangements are possible. In either case, the attachment process consists of a single step, as compared to multiple steps needed in conventional chip attachment (attachment of one chip at a time), demonstrating the significant increase of productivity.

FIGS. 2A and 2B of the example embodiment illustrate that each chip has eight terminals on a chip surface; the terminals are preferably aligned in an orderly, even symmetrical arrangement. The Figures furthermore show that the terminals have metal bumps 210. The chips may have a thickness of about 150 µm, and preferred bumps include round or square copper pillars, and squashed copper balls (as formed by wire bonding technology). Bumps 210 of an individual chip are spaced from each other by gaps 211. The attached chips of the set are oriented so that the metal bumps 210 of the chip terminal pads face away from the panel surface.

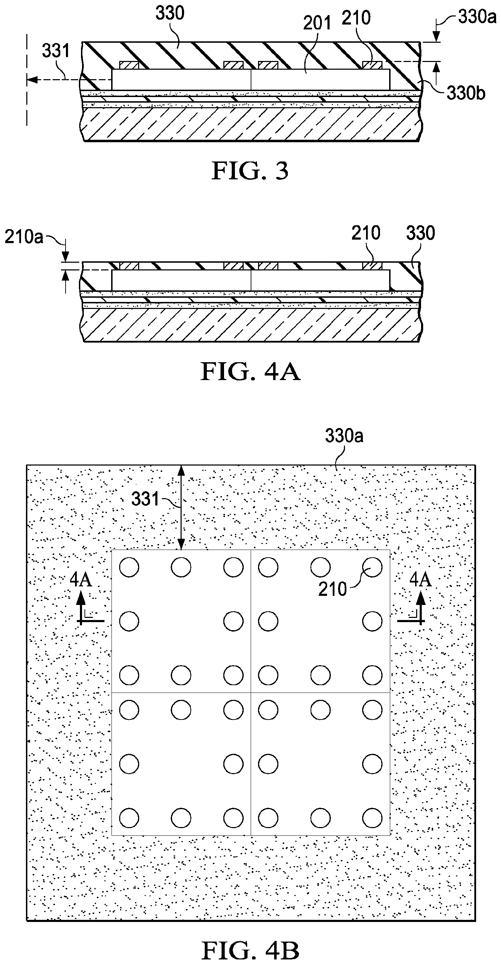

In the process step of FIG. 3, a compliant insulating material 330 is laminated, under vacuum suction, to cohesively fill any gaps 211 between the chip bumps and to cover the surfaces of chips 201 and bumps 210. Preferably, the height 330a of the laminated material over the bump tops is between about 15 µm and 50 µm. Also, the insulating material forms a frame 330b surrounding the rectangle sidewalls. The width 331 of the frame includes the portion needed for providing the area available for supporting the rerouted contact pads in subsequent process steps. The compliant material is selected to have a high modulus and a low CTE approaching the CTE of the semiconductor chips; it may be glass filled and may include liquid crystal polymers.

In the next process step, depicted in FIGS. 4A and 4B, a grinding technology is used to grind the insulating lamination material 330 uniformly until the tops of the metal bumps 210 are exposed. The grinding process may continue by removing some bump height until bumps 210 are flat with the planar surface of lamination material 330; preferably, the remaining bump height 210a is between about 25 and 50 µm. Thereafter, carrier 100 is transferred, with its assembly, to the vacuum and plasma chamber of an apparatus for sputtering metals.

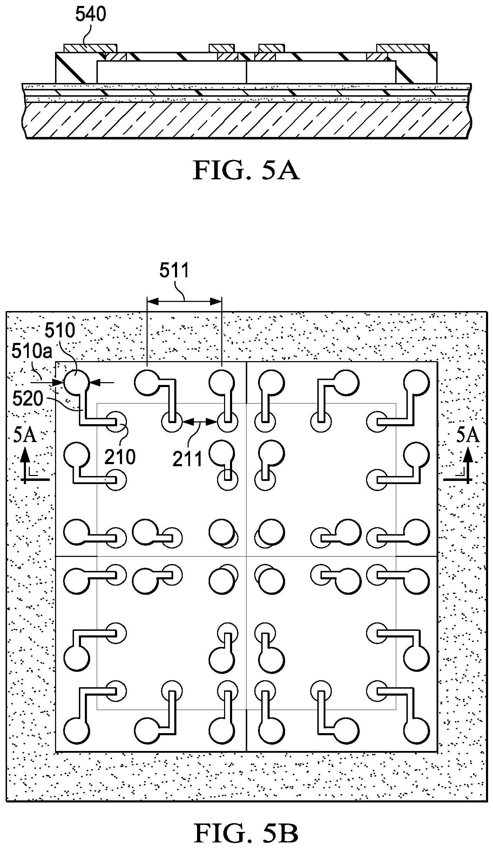

During the processes summarized in FIG. 5A and 5B, the assembly of carrier 100, with the exposed metal bumps and lamination surfaces, is plasma-cleaned, while the panel is cooled, preferably below ambient temperature. The plasma accomplishes, besides cleaning the surface from adsorbed films, especially water monolayers, some roughening of the surfaces; both effects enhance the adhesion of the sputtered metal layer. Then, at uniform energy and rate, at least one layer 540 of metal is sputtered onto the exposed bump and lamination surfaces across the carrier. The sputtered layer is adhering to the surfaces.

Preferably, the step of sputtering includes the sputtering of a first layer of a metal selected from a group including titanium, tungsten, tantalum, zirconium, chromium, molybdenum, and alloys thereof, wherein the first layer is adhering to chip and lamination surfaces; and without delay sputtering at least one second layer of a metal selected from a group including copper, silver, gold, and alloys thereof, onto the first layer, wherein the second layer is adhering to the first layer. The sputtered layers have the uniformity, strong adhesion, and low resistivity needed to serve, after patterning, as conductive traces for rerouting, see FIGS. 5A and 5B; the sputtered layers may also serve as seed metal for plated thicker metal layers.

In an optional step, at least one layer of metal is electroplated onto the sputtered layers 540. A preferred metal is copper. The plated layer is preferably thicker than the sputtered metal to lower the sheet resistance and thus the resistivity of the rerouting traces after patterning the plated and sputtered metal layers. The steps of patterning the sputtered and plated metal layers to create connecting traces between the bumps and enlarged package contact pads are preferably executed with a laser direct-imaging technology. The laser direct-imaging technology uses an out-alignment correcting technique.

In another optional step, one or more layers of solderable metal, such as tin, tin alloy, nickel followed by palladium, may be deposited.

The result of the metal layer patterning for rerouting and enlarged contact pads is illustrated in FIG. 5B. Compared to the original bumps 210 and their spacing 211, the new contact pads 510 benefit from the enlarged real estate by lamination (determined by frame width 331 in FIG. 3) and the customized rerouting. The new contact pads 510 have enlarged contact diameter 510a compared to the original bumps 210; they further have wider spacing 511 and a symmetrical layout. Also, connecting traces 520 from the pads to the chip terminals with bumps are enabled, which benefit from customized layouts, but have only negligibly small increases in resistance and inductance thanks to the high conductivity of the sputtered and plated metal layers.

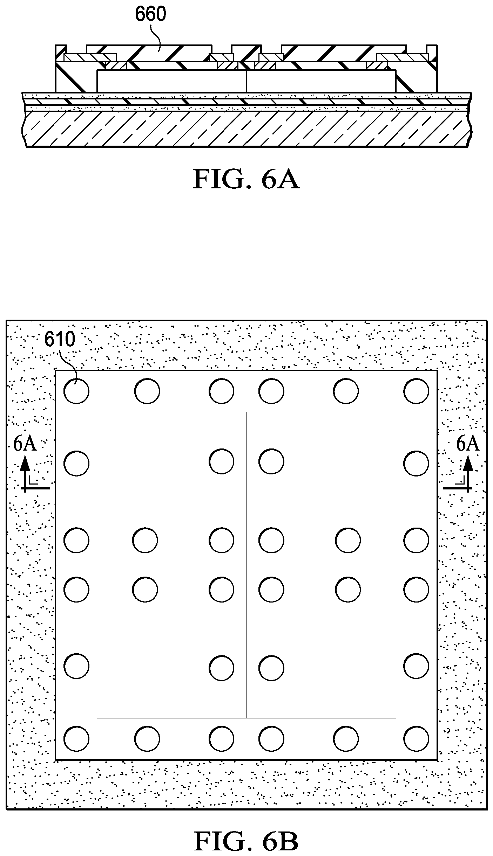

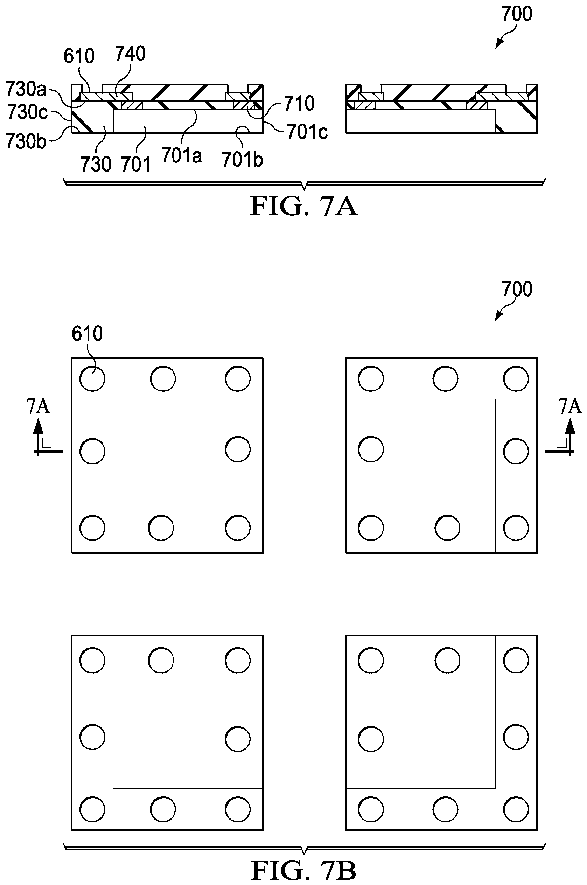

Also, it is preferred, as shown in FIGS. 6A and 6B, to deposit and pattern rigid insulating material 660, such as so-called solder resist, to protect and strengthen remaining chip areas not used for extended contacts; in the preferred application of the rigid insulating protection, only the extended contact areas 610 remain exposed and open as windows. The contact areas may be round, as shown in FIG. 7B, or square. To apply solder resist and other dielectric materials, photo-imagable materials, etchants, and others, a preferred technique uses an ultrasonic spray tool. With the rigid protection of insulating material 660, the assembly of the package for the chip set is completed. Dependent on the configuration of the contact areas 610, they may be applied as ball grid arrays, land grid arrays, and QFN-type contact pads.

In the next process step, the temperature is raised so that the temperature-sensitive first adhesive of layer 110 allows to remove panel 110 (substrate 101 and tape 102) from the assembly of packaged chip set.

The next process step, illustrated in FIGS. 7A and 7B, the packaged chip set is singulated into discrete devices 700. The preferred separating technique is sawing. For the example devices 700 shown in FIG. 7A, the singulation of the chip set creates units, which have contact pads 610, sidewalls 730c with exposed insulating lamination 730, and sidewalls 701c with exposed silicon 701. The exposed silicon areas offer an good opportunity for heat spreading and thus help to improve the thermal device characteristics.

Another embodiment is an example packaged semiconductor device 700. The device has a semiconductor chip 701 with a first surface 701a and a parallel second surface 701b. First surface 701a has multiple terminals 710 with metal bumps such as copper pillars or copper squashed balls.

Device 700 has a frame of insulating material 730 adhering to at least one sidewall of the chip. The insulating material of the frame includes glass fibers impregnated with a gluey resin, which has a high modulus and a coefficient of thermal expansion (CTE) close to the CTE of silicon. Frame 730 has a first surface 730a planar with the insulating material between the bumps 710, and a parallel second surface 730b planar with the second chip surface 701b.

Device 700 further has at least one film 740 of sputtered metal extending from the bumps 710 across the surface 730a of the layer of insulating material close to the edge of the insulating frame. Film 740 is patterned to form extended contact pads 610 over the frame, and, wherever necessary, rerouting traces between the chip bumps 710 and the extended contact pads 610. Because film 740 has been created by sputtering, it is adhering to all the surfaces mentioned.

Dependent on the size, contour, and metallurgical configuration of the extended contact pads 610, they can be employed as ball grid array terminals, land grid array terminals, and QFN-type terminals.

Modifications are possible in the described embodiments, and other embodiments are possible, within the scope of the claims. As an example, dependent on the size of the chip and the package, enough area can be utilized to lay out the redistributed contact pads for a considerably higher number of terminals than the eight contact pads discussed. As another example, for a set of four chips the configuration of chips as well as packages may be rectangular instead of square; the layout of the redistributed contact pads can be accommodated.

## Claims

1. A method of fabricating packaged semiconductor devices (700) in panel format, comprising:
providing a flat panel sheet as a carrier (100) including a stiff substrate (101) of an insulating plate suitable to maintain panel flatness, and a tape (102) having a surface layer (110) of a first adhesive releasable at elevated temperatures, a core base film (111), and a bottom layer (112) with a second adhesive, the bottom layer (112) attached to the substrate (101), the panel having lateral dimensions suitable for a set of contiguous semiconductor chips (201);
attaching a set of contiguous semiconductor chips (201) onto the first adhesive layer, the set forming a rectangle with sidewalls, the chip terminals having metal bumps (210) facing away from the first adhesive layer;
laminating, under vacuum suction, a compliant insulating material (330) to cohesively cover the chip terminal bumps (210) and to fill gaps between the bumps (210), and to form an insulating frame (330b) surrounding the rectangle sidewalls, the material having a coefficient of thermal expansion approaching the coefficient of the semiconductor chips (201);
grinding lamination material uniformly until the tops of the metal bumps (210) are exposed;
plasma-cleaning and cooling the panel and attached chip set in an equipment for sputtering metals; and
sputtering, at uniform energy and rate, at least one layer of metal onto the exposed lamination and terminal bumps (210).

2. The method of claim 1 wherein sputtering includes the sputtering of a first layer of a first metal selected from a group including titanium, tungsten, tantalum, zirconium, chromium, molybdenum, and alloys thereof, the first layer adhering to chip and lamination surfaces; and without delay sputtering at least one second layer of a second metal selected from a group including copper, silver, gold, and alloys thereof, onto the first layer, the second layer adhering to the first layer.

3. The method of claim 2 further comprising:
plating and patterning a layer of the second metal onto the sputtered layer of the second metal;
plating a layer of solderable metal onto selected areas of the plated second metal;
stripping selected areas of the sputtered metal layers;
depositing and patterning insulating material (660) over selected areas of the plated second metal;
removing the panel by raising the temperature to release the first adhesive; and
dicing the set of chips (201) to singulate discrete devices.

4. A packaged semiconductor device (700) comprising:
a semiconductor chip (701) having a first surface (701a) with terminals including metal bumps (710), and a parallel second surface (701b);
an insulating material comprising a frame (730) adhering to at least one sidewall of the chip (701) and a layer to fill gaps between the bumps (710), the insulating material having a coefficient of thermal expansion approaching the coefficient of the semiconductor chips (701), the frame (730) having a first surface (730a) planar with the layer of insulating material between the bumps (710), and a parallel second surface (730b) planar with the second chip surface, wherein at least one sidewall (701c) of the chip (701) is not covered by the frame (730) of insulating material; and
at least one film of sputtered metal extending from the bumps (710) across the surface of the layer of insulating material close to an edge of the insulating frame (730), the film patterned to form extended contact pads (610) over the frame (730) and rerouting traces between the chip bumps (710) and the extended contact pads (610).

5. The device of claim 4 wherein the sputtered film includes a first layer of a metal selected from a group including titanium, tungsten, tantalum, zirconium, chromium, molybdenum, and alloys thereof, the first layer adhering to the chip terminals, the surface of the insulating material, and frame surface; and at least one second layer of a metal selected from a group including copper, silver, gold, and alloys thereof, onto the first layer, the second layer adhering to the first layer.

6. The device of claim 5 further including at least one layer of plated metal adhering to the sputtered metals.

7. The device of claim 6 further including a patterned rigid material protecting exposed portions of the layer of insulating material and rerouting traces.

8. The device of claim 6 wherein the insulating material of the frame (730) includes glass fibers impregnated with a gluey resin having a high modulus and a coefficient of thermal expansion, CTE, close to the CTE of silicon.

9. The device of claim 4 wherein the configuration and metallurgy of the extended contact pads (610) are selected to be suitable to devices including land grid array devices, ball grid array devices, and quad flat no-lead, QFN, devices.

## Patentansprüche

1. Verfahren zur Fertigung von gehäusten Halbleiterbauteilen (700) im Paneelformat, umfassend:
Bereitstellen einer Flachpaneellage als Träger (100), der ein steifes Substrat (101) einer Isolierplatte, die geeignet ist, um die Flachheit des Paneels aufrechtzuerhalten, und ein Band (102) mit einer Oberflächenschicht (110) eines ersten Klebstoffs, der bei erhöhten Temperaturen lösbar ist, einen Kernbasisfilm (111) und eine Bodenschicht (112) mit einem zweiten Klebstoff einschließt, wobei die Bodenschicht (112) an dem Substrat (101) befestigt ist, wobei das Paneel laterale Abmessungen aufweist, die für ein Set zusammenhängender Halbleiterchips (201) geeignet sind;
Befestigen eines Sets zusammenhängender Halbleiterchips (201) auf der ersten Klebstoffschicht, wobei das Set ein Rechteck mit Seitenwänden bildet, wobei die Chipanschlüsse Metallkontaktflecken (210) aufweisen, die von der ersten Klebstoffschicht weg weisen;
Laminieren eines anschmiegsamen Isoliermaterials (330) unter Vakuumansaugung, um die Chipanschlusskontaktflecken (210) kohäsiv zu bedecken und Lücken zwischen den Kontaktflecken (210) zu füllen, und um einen Isolierrahmen (330b) zu bilden, der die Rechteckseitenwände umgibt, wobei das Material einen Wärmeausdehungskoeffizienten aufweist, der sich dem Koeffizienten der Halbleiterchips (201) annähert;
gleichförmiges Schleifen des Laminierungsmaterials, bis die oberen Bereiche der Metallkontaktflecken (210) exponiert sind;
Plasmareinigen und Kühlen des Paneels und befestigten Chipsets in einem Gerät zum Sputtern von Metallen; und
Sputtern von mindestens einer Metallschicht auf die exponierte Laminierung und die Anschlusskontaktflecken (210) mit gleichförmiger Energie und Rate.

2. Verfahren nach Anspruch 1, wobei Sputtern das Sputtern einer ersten Schicht eines ersten Metalls ausgewählt aus einer Gruppe, die Titan, Wolfram, Tantal, Zirconium, Chrom, Molybdän und Legierungen davon einschließt, wobei die erste Schicht an Chip- und Laminierungsoberflächen haftet; und ohne Verzögerung Sputtern mindestens einer zweiten Schicht eines zweiten Metalls ausgewählt aus einer Gruppe, die Kupfer, Silber, Gold und Legierungen davon einschließt, auf die erste Schicht einschließt, wobei die zweite Schicht an der ersten Schicht haftet.

3. Verfahren nach Anspruch 2, des Weiteren umfassend:
Plattieren und Strukturieren einer Schicht des zweiten Metalls auf die gesputterte Schicht des zweiten Metalls;
Plattieren einer Schicht aus lötfähigem Metall auf ausgewählte Bereiche des plattierten zweiten Metalls;
Strippen von ausgewählten Bereichen der gesputterten Metallschichten;
Abscheiden und Strukturieren von Isoliermaterial (660) über ausgewählten Bereichen des plattierten zweiten Metalls;
Entfernen des Paneels, indem die Temperatur erhöht wird, um den ersten Klebstoff zu lösen; und
Sägen (Dicing) des Sets von Chips (201) zum Vereinzeln (Singulieren) zu diskreten Bauteilen.

4. Gehäustes Halbleiterbauteil (700), umfassend:
einen Halbleiterchip (701) mit einer ersten Oberfläche (701a) mit Anschlüssen, die Metallkontaktflecken (710) einschließen, und einer parallelen zweiten Oberfläche (701b) ;
ein Isoliermaterial, das einen Rahmen (730), der an mindestens einer Seitenwand des Chips (701) haftet, und eine Schicht zum Füllen von Lücken zwischen den Kontaktflecken (710) umfasst, wobei das Isoliermaterial einen Wärmeausdehnungskoeffizienten aufweist, der sich dem Koeffizienten der Halbleiterchips (701) nähert, wobei der Rahmen (730) eine erste Oberfläche (730a), die mit der Schicht des Isoliermaterials zwischen den Kontaktflecken (710) planar ist, und eine parallele zweite Oberfläche (730b) aufweist, die mit der zweiten Chipoberfläche planar ist, wobei mindestens eine Seitenwand (701c) des Chips (701) nicht durch den Rahmen (730) des Isoliermaterials bedeckt ist; und
mindestens einen Film aus gesputtertem Metall, der sich von den Kontaktflecken (710) über die Oberfläche der Schicht aus Isoliermaterial nahe an einen Rand des Isolierrahmens (730) erstreckt, wobei der Film strukturiert ist, um erweiterte Kontaktpads (610) über dem Rahmen (730) zu bilden und Bahnen zwischen den Chipkontaktflecken (710) und den erweiterten Kontaktpads (610) umzuleiten.

5. Bauteil nach Anspruch 4, wobei der gesputterte Film eine erste Schicht eines Metalls ausgewählt aus einer Gruppe, die Titan, Wolfram, Tantal, Zirconium, Chrom, Molybdän und Legierungen davon einschließt, wobei die erste Schicht an den Chipanschlüssen, der Oberfläche des Isoliermaterials und der Rahmenoberfläche haftet; und mindestens eine zweite Schicht eines Metalls ausgewählt aus einer Gruppe, die Kupfer, Silber, Gold und Legierungen davon einschließt, auf der ersten Schicht einschließt, wobei die zweite Schicht an der ersten Schicht haftet.

6. Bauteil nach Anspruch 5, des Weiteren einschließend mindestens eine Schicht aus plattiertem Metall, die an den gesputterten Metallen haftet.

7. Bauteil nach Anspruch 6, des Weiteren einschließend ein strukturiertes starres Material, das exponierte Abschnitte der Schicht aus Isoliermaterial schützt und Bahnen umleitet.

8. Bauteil nach Anspruch 6, wobei das Isoliermaterial des Rahmens (730) Glasfasern einschließt, die mit einem klebrigen Harz imprägniert sind, das einen hohen Modul und einen Wärmeausdehungskoeffizienten, CTE, nahe dem CTE von Silicium aufweist.

9. Bauteil nach Anspruch 4, wobei die Konfiguration und Metallurgie der erweiterten Kontaktpads (610) so gewählt sind, dass sie für Bauteile einschließlich Land Grit Array- (LGA)-Bauteilen, Ball Grid Array- (BGA)-Bauteilen und Quad Flat No Leads- (QFN)-Bauteilen geeignet sind.

## Revendications

1. Procédé de fabrication de dispositifs semi-conducteurs mis en boîtier (700) dans un format de panneau, comprenant :
l'obtention d'une feuille de panneau plat servant de support (100) comportant un substrat rigide (101) constitué d'une plaque isolante appropriée pour conserver une planéité de panneau, et un ruban (102) ayant une couche de surface (110) d'un premier adhésif détachable à des températures élevées, un film de base central (111) et une couche inférieure (112) avec un deuxième adhésif, la couche inférieure (112) étant fixée au substrat (101), le panneau ayant des dimensions latérales appropriées pour un ensemble de puces semi-conductrices contiguës (201) ;
la fixation d'un ensemble de puces semi-conductrices contiguës (201) sur la première couche d'adhésif, l'ensemble formant un rectangle avec des parois latérales, les bornes de puce ayant des bosses métalliques (210) à l'opposé de la première couche d'adhésif ;
le pelliculage, sous aspiration sous vide, d'un matériau isolant enrobant (330) pour recouvrir de façon cohésive les bosses de borne (210) des puces et pour remplir des espaces entre les bosses (210), et pour former un cadre isolant (330b) entourant les parois latérales du rectangle, le matériau ayant un coefficient de dilatation thermique se rapprochant du coefficient des puces semi-conductrices (201) ;
le meulage uniforme du matériau de pelliculage jusqu'à ce que les sommets des bosses métalliques (210) soient exposés ;
le nettoyage par plasma et le refroidissement du panneau et de l'ensemble de puces fixées dans un équipement destiné à la pulvérisation de métaux ; et
la pulvérisation, à une énergie et une vitesse uniformes, d'au moins une couche de métal sur le pelliculage et les bosses de borne (210) exposés.

2. Procédé de la revendication 1 dans lequel la pulvérisation comporte la pulvérisation d'une première couche d'un premier métal choisi dans un groupe comportant le titane, le tungstène, le tantale, le zirconium, le chrome, le molybdène et les alliages de ceux-ci, la première couche adhérant aux surfaces des puces et du pelliculage ; et sans délai, la pulvérisation d'au moins une deuxième couche d'un deuxième métal choisi dans un groupe comportant le cuivre, l'argent, l'or et les alliages de ceux-ci, sur la première couche, la deuxième couche adhérant à la première couche.

3. Procédé de la revendication 2 comprenant en outre :
le placage et le modelage d'une couche du deuxième métal sur la couche pulvérisée du deuxième métal ;
le placage d'une couche de métal soudable sur des zones sélectionnées du deuxième métal plaqué ;
le décapage de zones sélectionnées des couches de métal pulvérisées ;
le dépôt et le modelage d'un matériau isolant (660) sur des zones sélectionnées du deuxième métal plaqué ;
le retrait du panneau par élévation de la température pour détacher le premier adhésif ; et
le découpage de l'ensemble de puces (201) pour individualiser des dispositifs discrets.

4. Dispositif semi-conducteur mis en boîtier (700) comprenant :
une puce semi-conductrice (701) ayant une première surface (701a) avec des bornes comportant des bosses métalliques (710), et une deuxième surface parallèle (701b) ;
un matériau isolant comprenant un cadre (730) adhérant à au moins une paroi latérale de la puce (701) et une couche servant à remplir des espaces entre les bosses (710), le matériau isolant ayant un coefficient de dilatation thermique se rapprochant du coefficient de la puce semi-conductrice (701), le cadre (730) ayant une première surface (730a) planaire avec la couche de matériau isolant entre les bosses (710), et une deuxième surface parallèle (730b) planaire avec la deuxième surface de puce, au moins une paroi latérale (701c) de la puce (701) n'étant pas recouverte par le cadre (730) de matériau isolant ; et
au moins un film de métal pulvérisé s'étendant depuis les bosses (710) à travers la surface de la couche de matériau isolant près d'un bord du cadre isolant (730), le film étant modelé pour former des plots de contact étendus (610) pardessus le cadre (730) et des traces de réacheminement entre les bosses de puce (710) et les plots de contact étendus (610).

5. Dispositif de la revendication 4 dans lequel le film pulvérisé comporte une première couche d'un métal choisi dans un groupe comportant le titane, le tungstène, le tantale, le zirconium, le chrome, le molybdène et les alliages de ceux-ci, la première couche adhérant aux bornes de puce, à la surface du matériau isolant et à la surface de cadre ; et au moins une deuxième couche d'un deuxième métal choisi dans un groupe comportant le cuivre, l'argent, l'or et les alliages de ceux-ci, sur la première couche, la deuxième couche adhérant à la première couche.

6. Dispositif de la revendication 5 comportant en outre au moins une couche de métal plaqué adhérant aux métaux pulvérisés.

7. Dispositif de la revendication 6 comportant en outre un matériau rigide à motif protégeant des parties exposées de la couche de matériau isolant et des traces de réacheminement.

8. Dispositif de la revendication 6 dans lequel le matériau isolant du cadre (730) comporte des fibres de verre imprégnées avec une résine collante ayant un module élevé et un coefficient de dilatation thermique, CTE, proche du CTE du silicium.

9. Dispositif de la revendication 4 dans lequel la configuration et la métallurgie des plots de contact étendus (610) sont sélectionnées pour être adaptées à des dispositifs incluant les dispositifs à boîtier matriciel à plots, les dispositifs à boîtier matriciel à billes, et les dispositifs à boîtier plat sans broches, QFN.
